(19) Europäisches Patentamt
European Patent Office
Office européen des brevets

(11) **EP 1 921 178 A1**

(12) **EUROPEAN PATENT APPLICATION**

(43) Date of publication:
**14.05.2008 Bulletin 2008/20**

(51) Int Cl.:
*C23C 16/24* (2006.01)     *C23C 16/511* (2006.01)
*H01J 37/32* (2006.01)     *H01L 31/20* (2006.01)

(21) Application number: **06301113.4**

(22) Date of filing: **02.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicants:
- **Dow Corning Corporation**
  **Midland, MI 48611-0994 (US)**
- **Ecole Polytechnique**
  **91128 Palaiseau (FR)**

(72) Inventors:
- **Roca i Cabarrocas , Pere**
  **91140 Villebon sur Yvette (FR)**
- **Bulkin, Pavel**
  **c/o 4C Residence Clos d'Alençon**
  **91140 Villebon dur Yvette (FR)**

- **Daineka Dmitri**
  **91120 Palaiseau (FR)**
- **Dao , Thien Hai**
  **Ecole Poly. Lab. de Phy. des Inter. et Co. et Mi.**
  **91228 Palaiseau (FR)**
- **Leempoel, Patrick**
  **1180 Brussels (BE)**
- **Descamps , Pierre**
  **1330 Rixenart (BE)**
- **Kervyn de Meerendré**
  **1150 Brussels (BE)**

(74) Representative: **Boon, Graham Anthony et al**
**Elkington and Fife LLP,**
**Prospect House,**
**8 Pembroke Road**
**Sevenoaks,**
**Kent TN13 1XR (GB)**

(54) **Film deposition of amorphous films by electron cyclotron resonance**

(57)     A method is disclosed for forming a film of an amorphous material, for example amorphous silicon, on a substrate (14), by deposition from a plasma. A substrate is placed in an enclosure having a defined volume, and a film precursor gas, for example silane, is introduced into the enclosure through pipes (20). Unreacted and dissociated gas is extracted from the enclosure through exit (22) so as to provide a low pressure in the enclosure. Microwave energy is introduced into the gas within the enclosure to produce a plasma therein by distribution electron cyclotron resonance, and cause material to be deposited from the plasma on the substrate. The normalised precursor gas flow rate, defined as the precursor gas flow rate, divided by the area of the distributed plasma source, is greater than or equal to 700sccm/m$^2$, and the gas residence time, defined as the volume of the reactor divided by the effective precursor gas pumping rate, is not more than 30ms.

Figure 3a

**Description**

This invention relates to a method for forming a film of an amorphous material by deposition from a plasma on to a work surface. More particularly, it concerns the use of microwave energy to produce the plasma by electron cyclotron resonance. One area of particular interest is in depositing a film of amorphous silicon (a-Si:H) by dissociation of a silane, for example $SiH_4$, $Si_2H_6$ or a higher order of oligomer, in a process known as plasma-enhanced CVD (chemical vapor deposition). Other precursor gases which can be used to deposit amorphous silicon, or amorphous silicon alloys, include molecules in which silicon is present in combination with one or more of carbon, oxygen, or nitrogen, optionally together with hydrogen. An example of a silicon alloy is a structure of the type denoted by $SiO_xN_y$. Further, silicon-containing gases may be used together with other gases, for example germane, or gases not containing silicon may be used to deposit other films. One area of particular interest as regards the use of amorphous silicon films is in devices for converting solar energy into electrical power. Such amorphous silicon material can also find use in electronic applications such as TFT for display. As used herein, the term "amorphous silicon" denotes hydrogenated amorphous silicon, a-Si:H. For use in the areas just mentioned, some hydrogen must be present, typically 3-20%, to passivate the dangling bonds which are defects.

In the technical field of exciting a plasma to electron cyclotron resonance (hereinafter abbreviated to "ECR"), resonance is obtained when the frequency of gyration of an electron in a static or quasi-static magnetic field is equal to the frequency of the applied accelerating electric field. This resonance is obtained for a magnetic field B at an excitation frequency f which is related to B by the following relationship:

$$B = 2\pi mf / e \qquad (1)$$

wherein m and e are the mass and the charge of an electron.

When exciting a plasma at electron cyclotron resonance frequency electrons revolve in phase with the electric field and continuously gain energy from the external excitation source where the ECR condition (1) is met such as to reach the threshold energy necessary for dissociating or ionizing the gas. To satisfy this condition, it is necessary firstly that the electron remains trapped in the magnetic field lines, i.e. that its radius of gyration is small enough with respect to the static magnetic field gradient for the electron to see a substantially constant magnetic field during its gyration, and secondly that the frequency of gyration remains large relative to the frequency of collision between electrons and neutral elements such as atoms and/or molecules. In other words, the best conditions for exciting a plasma to electron cyclotron resonance are expected to be obtained when simultaneously the gas pressure is relatively low and the excitation frequency f is high, which also means that the magnetic field intensity B must be high.

A major difficulty with conventional divergent ECR is that it is not possible to produce a plasma whose density is substantially uniform over a large area. This means that it cannot be used, for example, to deposit a substantially uniform layer of material on a work surface of large size. To overcome this problem, a technique has been developed which is known as distributed electron cyclotron resonance (DECR), which employs an apparatus in which a plurality of plasma excitation devices is formed into a network, with the devices collectively generating a plasma whose density is substantially uniform at the work surface. The individual plasma excitation devices are each constituted by a wire applicator of microwave energy, having one end connected to a source for producing microwave energy and having an opposite end fitted with at least one magnetic dipole for creating at least one surface having a magnetic field that is constant and of an intensity corresponding to electron cyclotron resonance. The dipole is mounted at the end of the microwave applicator in such a manner as to ensure that electrons accelerated to electron cyclotron resonance oscillate between the poles so as to create a plasma diffusion zone situated on the side of the dipole that is remote from the end of the applicator. The individual excitation devices are distributed relative to one another and in proximity with the work surface so as to create together a plasma that is uniform for the work surface.

Such a DECR apparatus is described in US Patent No. 6,407,359 (corresponding to EP-1075168), and more detailed discussion of the apparatus described therein is given below, with reference to drawings. As is apparent from those drawings, excitation devices, as viewed from the substrate, take the form of a generally rectangular array, by which we include also the particular case where the rectangle is a square, and such an apparatus is therefore sometimes referred to as matrix DECR (MDECR) apparatus. It is to be understood, however, that the present invention could also be applied to a DECR apparatus where the excitation devices were arranged in a non-rectangular two-dimensional network, for example in a hexagonal network or where there are two parallel lines of devices, with the devices in one line being offset with respect to one another. An example of a hexagonal array is given in "Determination of the EEDF by Langmuir probe diagnostic in a plasma excited at ECR above a multipolar magnetic field", T. Lagarde, Y. Arnal, A. Lacoste, J. Pelletier, Plasma Sources Sci. Technol. 10, 181-190, 2001. The devices could also be disposed as a circular, part-circular, or near-circular array. It should be noted that in some work done by the present inventors, depositions have been carried out with a central plasma excitation device being surrounded by three or six devices, the surrounding devices having the polarity of their magnets being oppositely disposed to the magnet of the central device and being arranged in a triangular or hexagonal array respectively.

Furthermore, the invention can be applied to a DECR apparatus which is not of an MDECR type. Thus, for example, it is applicable to a DECR reactor which, historically, preceded the MDECR type, and which has a cylindrical shape and uses long antennas and magnets that extend from the top to the bottom of the cylinder. Such arrangement is described in "Microwave Excited Plasmas" by Michel Moisan and Jacques Pelletier, Elsevier, 1992, and would be suitable for homogeneously coating a cylindrical substrate such as a tube or an object which is characterized by a dimension (length, radius) which is small as compared to the plasma ambipolar mean free path (See above reference, Appendix 9.1 page 269-271). This object can have a flat surface lying in the central part of the plasma and oriented perpendicular to the axis of the cylinder.

We have surprisingly found that the quality of amorphous silicon films deposited by a DECR process can be improved by increasing the flow rate of gaseous precursor fed into the reactor. Increasing the flow rate of silane, or other precursor gas, is found to decrease the material bandgap and the hydrogen content in the film, both of which are signs of film quality improvement. In addition, film photoconductivity also increases, showing that the improvement in film structure is also accompanied by a reduction of the defect density. An increase in film density is also observed when the silane flow rate is increased, but only when operating at low gas residence time. For a residence time, as defined below, of > 30 ms, no positive impact on film density is observed when increasing the silane flow rate.

One of the most surprising aspects of the present invention is that the film quality improvements are observed for very different values of the microwave power fed into the DECR reactor. High quality amorphous silicon films are deposited within a very broad range of microwave power.

We also found that decreasing the gas residence time for a constant silane flow rate increases the minority carrier diffusion length of the film, $L_d$ (another measure of the film electronic quality improvement), highlighting the fact that it is the combination of a large silane flow rate and a low gas residence time that is important for depositing a film that possesses both the optical and electronic solar grade properties. It should also be mentioned that increasing the silane flow rate to improve material quality results in a higher deposition rate. All the results used to document the present invention have been measured on films deposited at a rate in excess of 20Å/s.

In summary, we have found a new process regime for DECR reactor operation that leads to deposition of amorphous silicon films having improved optical and electronic properties, at a rate much larger than state of the art deposition rate for a solar grade a-Si film.

According to the invention there is provided a method for forming a film of an amorphous material on a substrate, by deposition from a plasma, which comprises placing the substrate in an enclosure having a defined volume, continuously introducing into the enclosure a film precursor gas at a flow rate, extracting unreacted and dissociated gas from the enclosure so as to provide a low pressure in the enclosure, and introducing microwave energy into gas within the enclosure to produce a plasma therein by distributed electron cyclotron resonance (DECR) and cause material to be deposited from the plasma on the substrate, wherein the normalised precursor gas flow rate, defined as the precursor gas flow rate, divided by the area of the distributed plasma source, is greater than or equal to 700sccm/m$^2$, and the gas residence time, defined as the volume of the reactor divided by the effective precursor gas pumping rate, is not more than 30ms.

Reference is made herein to hot electron confinement zones and a hot electron confinement envelope. These are defined as follows.

The hot electron confinement zones are those regions in which the hot (fast) primary electrons are trapped. These are regions in which the electrons oscillate between two adjacent magnet poles of opposite polarity, which could be two poles of a single magnet (hereinafter referred to as "intra-magnet poles") or poles of two adjacent magnets (hereinafter referred to as "inter-magnet poles"), in which the adiabatic approximation condition is met (Larmor radius is small with respect to the magnetic field gradient), and in which the electrons gain energy by crossing regions where the ECR coupling condition is met.

The magnets and the hot electron confinement zones define a hot electron confinement envelope. This is a volume which is the envelope of the array of magnets, expanded parallel to the magnetic axes of the magnets in both directions by the distance by which the inter-magnet zones (if any) extend beyond the ends of the magnets, and expanded perpendicular to the magnetic axes of the magnets in all directions by the distance by which the intra-magnet zones extend beyond the outward facing surfaces of the magnets.

The invention is further described below with reference to the accompanying drawings, in which:

Figure 1 is a diagrammatical elevation view showing a plasma production apparatus as described and shown in EP-1075168, omitting the means for introducing and extracting gas, which are shown separately in Figure 3a to 3d;

Figure 2 is a plan view of the apparatus of Figure 1;

Figures 3a to 3d show four possible ways of introducing gas into the apparatus and extracting gas from the apparatus; and

Figure 4 is a graph showing the relationship between material bandgap and normalized gas flow rate;

Figures 5 to 7 are graphs showing the relationship between three other properties and gas residence time; and

Figures 8a and 8b show the hot electron confinement envelope for two particular magnet configurations.

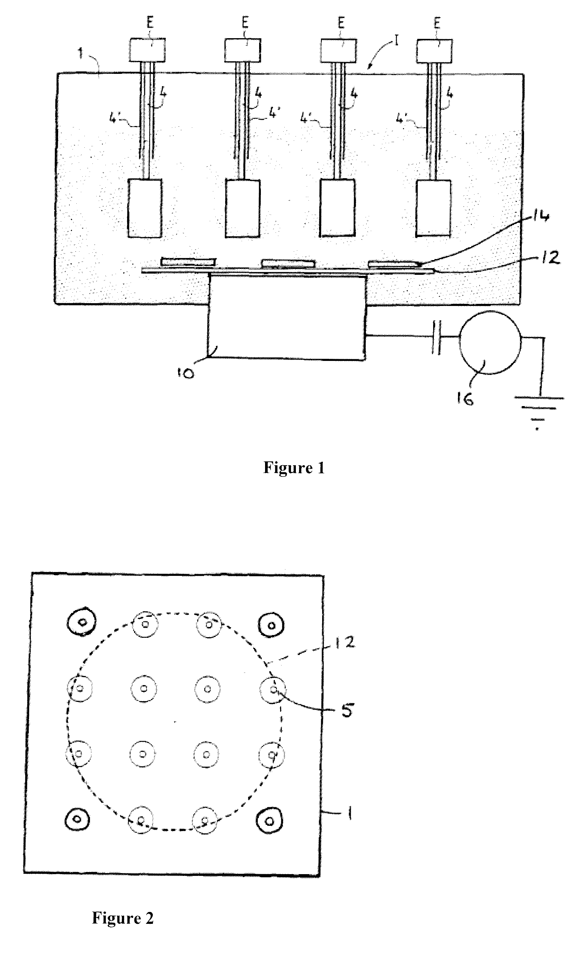

Figures 1 and 2 show an apparatus for producing a plasma relative to a substrate on which a film is to be deposited. The apparatus comprises a sealed enclosure 1 represented diagrammatically and fitted with devices for admitting gas and for pumping gas out (not shown in Figure 1), that enable the pressure of the gas that is to be ionized, or dissociated to be maintained at a desired value which, for example, can be about $10^{-2}$ to $2 \times 10^{-1}$ Pascals, depending on the nature of the gas and the excitation frequency. However, gas pressures less than $10^{-2}$ Pa (say down to $10^{-4}$ Pa, for example), or above $2 \times 10^{-1}$ Pa (say up to $5 \times 10^{-1}$ Pa, or even 1Pa or more) can be used. For example, pumping can be carried out by a 1600 1/s Alcatel Turbo-molecular pump, which serves to extract gas from the enclosure.

Gas is admitted to the enclosure from an appropriate gas source, e.g. a cylinder of gas under pressure, under the control of a mass flow controller (MFC). The gas may, for example, comprise $SiH_4$ as a film precursor gas, or one of the other gases mentioned above in relation to the deposition of amorphous silicon. In addition to the film precursor there may also be introduced a non-reactive diluent gas, such as He, Ne or Ar, a reactive gas, such as hydrogen, nitrogen or oxygen, or a dopant gas such as diborane, trimethyl boron or phosphine. Typically any such other gases are introduced into the enclosure through the same port or ports as the film precursor gas, as a mixture therewith, but they could be introduced separately. The gas feeding system should ensure the appropriate flow of gases, which typically ranges from 1 to 1000 sccm (standard cubic centimetre per minute), into the reactor.

The injection port for the gas generally consists of a single tube, or a plurality of tubes, entering the deposition chamber. The tube, or each tube, if there is more than one, can be extended by a grid to ensure more even distribution of the gas inside the deposition chamber. Injection can be carried out anywhere in the reactor but it is preferred to direct the film precursor gas towards the substrate surface. As used herein, it is to be understood that the reference to the outlet being arranged to direct gas towards the substrate surface covers not only the case where the gas is aimed directly at the substrate surface on which the film is to be deposited, but also any case where the said surface is wholly within an angle defined between a line extending from the outlet, in the direction of gas flow therefrom, and a line which is at right angles thereto and passes through the outlet. Under such circumstances the gas flow emerging from the outlet will have a vector component towards all portions of the said surface.

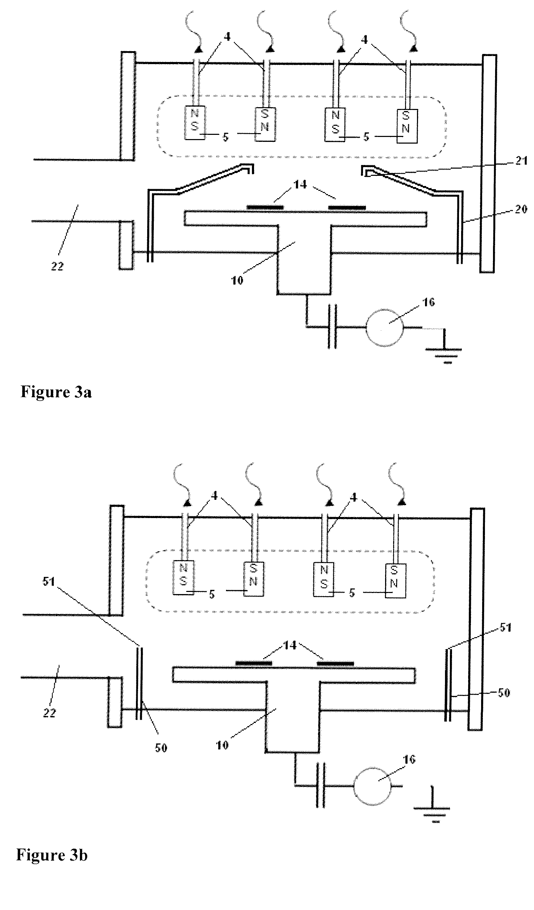

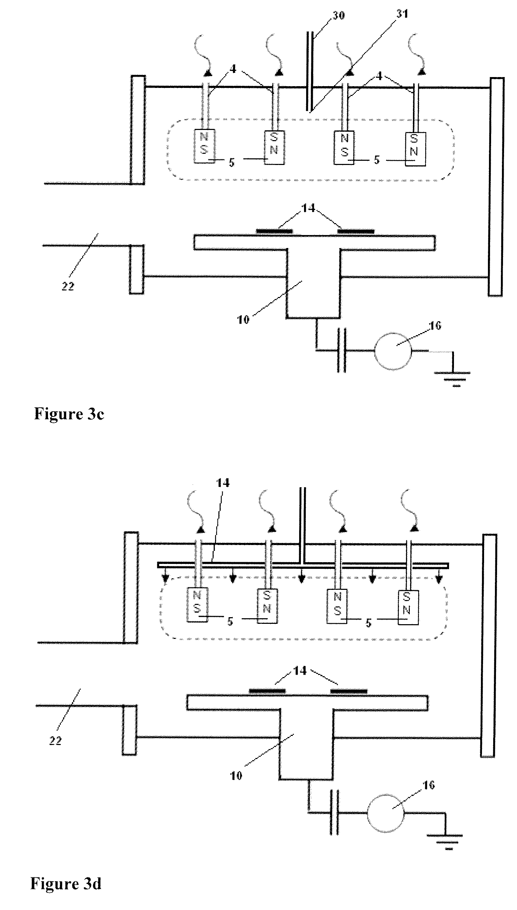

One way of carrying out the injection, referred as "point" injection, is shown diagrammatically in Figure 3a. In this arrangement the film precursor is introduced through a pipe, or a plurality of pipes 20 (two are shown), each of which has its outlet 21 located between the hot electron confinement envelope (shown approximately by a broken line) and the substrate surface, and directed towards that surface. Figure 3a also shows an exit 22 through which unreacted and dissociated gas is pumped out. Other features of Figure 3a are described below with reference to the apparatus shown in Figure 1. Other injection arrangements of particular interest are ones consisting of feeding the gas through a tube 30 having an outlet 31 (Figure 3c) or a grid 40 (Figure 3d) located "inside" the hot electron confinement envelope. In Figure 3d the locations at which the gas leaves are shown by arrows, and it will be understood that the grid extends perpendicular to the plane of the paper, as well as laterally, so that there are injection points spread over the whole of the hot electron confinement envelope. Yet another possible injection arrangement, referred to a "volume" injection, is shown in Figure 3b. Here the gas enters the deposition chamber at a location, or a plurality of locations (two are shown) spaced significantly from both the substrates and the hot electron confinement envelope. Figure 3b shows this being done via pipes 50 having outlets 51. The relative merits of these and other injection arrangements are discussed in our copending applications filed on the same date as the present application and entitled "Method and apparatus for forming a film by deposition from a plasma" and "Device for forming a film by deposition from a plasma'' (our references G28331EP and G28332EP).

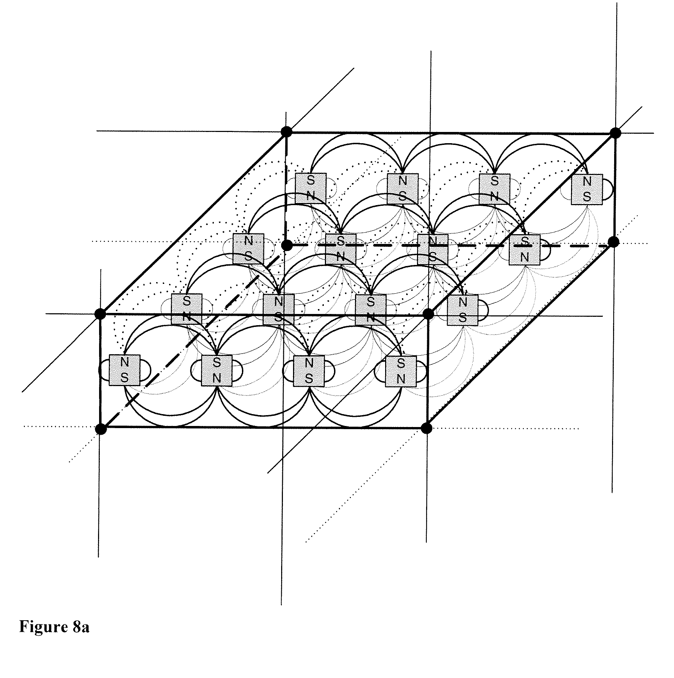

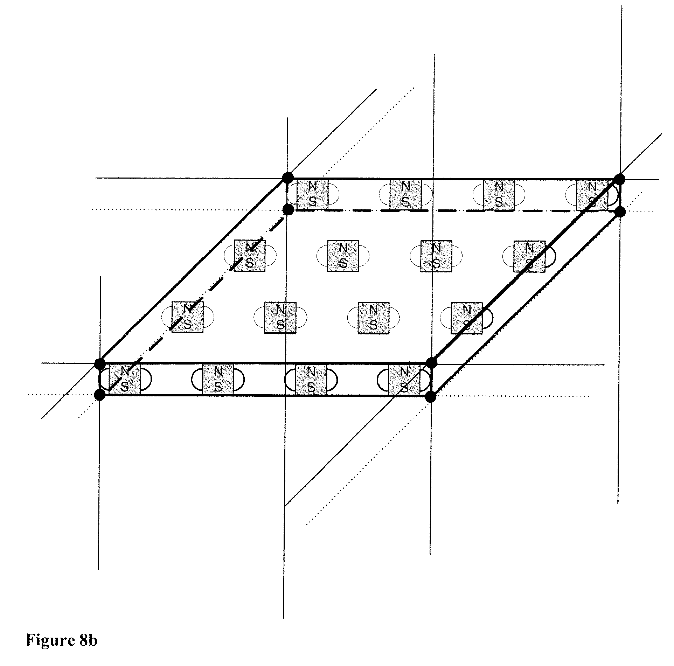

As mentioned above, Figures 8a and 8b show the hot electron confinement envelope for two particular magnet configurations. In each figure the envelope is indicated by the parallelepiped box drawn in bold lines. Figure 8a shows the case of a wholly multipolar configuration, in which every magnet is oppositely disposed to each of its intermediate neighbours. Figure 8b shows the case of a homopolar configuration, in which all magnets are identically orientated. Appropriate envelopes can be constructed for other magnet configurations, for example ones in which all the magnets in a given row have the same orientation, but adjacent rows are of opposite orientation to one another.

The plasma chamber is equipped with a substrate holder 10, which is shown as a fixed part of the apparatus.

One function of the substrate holder is to heat the substrates to the required deposition temperature. This is typically between room temperature and 600°C, and in the case of the deposition of amorphous silicon is preferably in excess of 200°C, more preferably between 225°C and 350°C. The temperature being referred to here is the actual substrate temperature, as opposed to the nominal substrate temperature which may be measured by measuring the temperature of the substrate holder. The significance of the distinction is discussed further in our co-pending application filed on the same date as the present application and entitled "Method for forming a film of amorphous silicon by deposition from a plasma" (our reference G27558EP).

A carrier plate 12, having thereon at least one substrate 14, and optionally a plurality of such substrates, is removably mounted on the holder 10, so that it can be brought into the chamber with substrates to be coated, and removed from the chamber with the substrates after they have been coated. However, alternatively the substrate can be glued directly on the substrate holder, using a thermally conductive glue. This improves thermal contact between the substrate and the substrate holder, which is otherwise difficult to achieve under low pressure conditions. This is discussed further in our co-pending application filed on the same date as the present application and entitled "Method for forming a film of amorphous silicon by deposition from a plasma" (our reference G27558EP). In this case the holder, with its substrates, needs to be introduced into the enclosure prior to the deposition process, and removed from it afterwards. If gluing is not used, one way to try to improve the heating of the substrate is to precede the low pressure film deposition step by a step in which the enclosure is filled with gas at a relatively high pressure (typically around 100-200 Pa). The high pressure gas provides thermal transfer across whatever gap may exist between the substrate and the heated holder, ensuring initial heating of the substrates. Another possibility is to place a thermally conductive carbon film between the substrate and the substrate holder. The substrate holder can be heated by circulating a hot fluid inside it, but heating could alternatively be achieved by electrical heating resistors embedded in the substrate holder. Alternatively, however, it is possible to heat the substrates directly, for example by using infrared lamps.

Another function of the substrate holder is to allow polarization of the substrate surface such as to control the energy of ions towards the substrate. Polarization can be achieved using either a source of RF voltage or using a DC voltage and requires the substrate holder to be electrically insulated from ground. Polarization is achieved by connecting the electrically insulated substrate holder to an appropriate RF or DC generator 16 with an adequate matching circuit in the case of RF polarization. When depositing on an insulating substrate, or on an insulating layer previously deposited on a substrate (which may or may not be insulating), the use of an RF generator is preferred. When depositing on a conductive substrate or on a conductive layer previously deposited on a substrate which may or may not be conductive, the bias can be applied by either an RF or DC generator with suitable electrical connection to the substrate surface. In a specific embodiment an RF-bias was applied using a 13.56 MHz Dressler generator connected to the substrate holder via an automatic tuning box. Even when using an RF generator, the resulting bias on the substrate surface comprises a DC bias component, as a result of conditions in the plasma. An explanation of how this occurs can be found, in the content of the description of a completely different plasma process, in Suzuki et al. "Radio-frequency biased microwave plasma etching technique: A method to increase SiO2 etch rate", J. Vac. Sci. Technol. B 3(4), 1025-1033, Jul/Aug 1985.

The plasma production apparatus I has a series of individual plasma excitation devices 3 spaced apart from one another and located in the proximity of the substrates, so as to operate together to create a plasma that is uniform for the substrates. Each individual plasma excitation device 3 comprises an elongate microwave energy applicator 4. Each applicator 4 has one of its ends connected to a respective microwave energy source, which lies outside the enclosure 1. Alternatively, however, a single microwave energy source can feed microwaves to all the applicators 4, or there can be a plurality of energy sources fewer in number than the number of applicators. For example, an array of sixteen applicators can conveniently be fed by two 2.45 GHz microwave generators, each of 2kW maximum power, and each feeding eight applicators via a power splitter and respective slug tuners. Each applicator 4 is advantageously in the form of a tube surrounded by a coaxial tube 4', thus enabling microwave energy to propagate to the free end thereof while avoiding radiating microwaves, and reducing microwave coupling between the applicators. In order to ensure proper transfer of the microwave energy into the plasma, each applicator is preferably equipped with a matching device that minimizes, or at least reduces, the reflected power.

Each microwave applicator 4 has its free end connected to at least one permanent magnet 5. Each magnet (preferably) has its magnetic axis parallel to the long axis of the magnet itself. In one particular form of this arrangement all the plasma excitation devices have their magnets oriented in the same direction (a monopolar configuration). i.e. all their north poles are at the top and all their south poles are at the bottom, or vice versa. In another, some of each pole are at the top and some of each pole are at the bottom (a multipolar configuration). An example of the latter is an array, where, viewed from one end as in Fig. 2, and passing along any given row or column of devices, one successively encounters poles of alternate polarity. Yet another example is where all the magnets in a given row (or column) have the same polarity, but the columns (or rows) are of alternative polarity. However, arrangements can also be used where the magnetic axes of the magnets are not parallel to the long axes of the magnets themselves, provided there are significant regions where the lines of the magnetic field are parallel to the propagation vector of microwaves. This is necessary in order to ensure the existence of significant regions where ECR damping can occur.

As indicated above, the present invention is based on the realisation of the significance of precursor gas flow rate and gas residence time, in achieving certain derivable properties for the deposited film. The influence of these factors will now be described in more detail, based on the experimental results, set out on Table 1 and 2, of 25 examples of DECR film deposition, carried out using $SiH_4$ as a precursor gas to form films of amorphous silicon. The films were deposited on a Coming 1737 glass, except where the resulting product was to be subjected to infra-red analysis, in which case they were deposited on a silicon wafer. For simplicity of analysis, no additional gases were used in the carrying out of these examples. In each deposition procedure a plurality of substrates were mounted on the substrate holder, with gaps between them. The volume of the enclosure was 25.51. The area of the distributed plasma source, which is taken to be the area enclosed by a line, in a horizontal plane, forming an envelope to the magnets, was 702 $cm^2$, i.e. 0.0702 $m^2$. The headings used in Tables 1 and 2 have the following meanings:

Injection: The type of injection used, i.e. point or tube.

$SiH_4/m^2$ (sccm/$m^2$):    the silane flow rate (rate of introduction of $SiH_4$) in standard $cm^3$ per minute, normalised by dividing it by the area of the distributed plasma source, i.e. 0.0702 $m^2$.

Residence time:    the residence time of the precursor gas, in the enclosure, expressed in ms. The definition of residence time is explained in more detail below.

MW/gas (W/sccm):    the microwave power (in W), normalised by dividing it by the silane flow rate in standard $cm^3$ per minute.

RF bias (volts):    the bias applied to the substrate, i.e. the DC bias achieved by using an applied RF voltage.

Temp (C):    the nominal temperature of the substrate in °C. It accurately represents the surface temperature for the samples 18-24. It is the substrate holder temperature for the samples 1-17, and the substrate surface temperature is likely to be 50-75°C below the substrate holder temperature due to poor thermal contact.

Pgas (mTorr):    the gas pressure in the enclosure in mTorr (1 mTorr = 0.1333 Pa).

Pplasma (mTorr):    the gas pressure in mTorr in the presence of plasma.

d (A):    the thickness of the film deposited in Å measured by spectroscopic ellipsometry according the method described in A. Fontcuberta i Morral, P. Roca i Cabarrocas, C. Clerc, "Structure and hydrogen content of polymorphous silicon thin films studied by spectroscopic ellipsometry and nuclear measurements", PHYSICAL REVIEW B 69, 125307/1-10, 2004.

Rough (Å):    the roughness of the surface of the deposited film in Å, as measured by spectroscopic ellipsometry according to the method referred to above.

Rate (Å/s):    the rate of film deposition in Å (thickness) per second.

$\varepsilon_i$(max):    the maximum value of the modelled imaginary part, $\varepsilon_i$(max), of the film dielectric constant $\varepsilon$, which is closely linked to the material density, where density changes are due to a change in the void volume (the maximum value is quoted since $\varepsilon_i$ varies with wavelength, and the maximum can occur at various different wavelengths) and measured by spectroscopic ellipsometry according the method referred above, using the Tauc-Lorentz model.

Eg (eV):    the material bandgap in eV measured by spectroscopic ellipsometry according the method referred above.

C:    the matrix disorder coefficient of the film material measure spectroscopic ellipsometry according the method referred by above.

Ld (nm):                    the minority carrier diffusion length in nm.

IF0:                        the illumination factor, which is the ratio between the photoconductivity and the dark conductivity of the film

Sigma phot (1/ohm.cm):      the film photoconductivity, measured under uncalibrated but constant white light illumination in $(ohm.cm)^{-1}$.

Various characterization techniques were used to assess the optical and electronic quality of the amorphous silicon films produced.

Optical properties were measured by spectroscopic ellipsometry, in an energy range of I .5-4eV, which allows accessing:

- The optical bandgap of the film.

    o A small bandgap is required for photovoltaic applications as it means an absorption of the incident light in a broader wavelength range.
    o Typically a small bandgap is also associated with a low film hydrogen content, which has a positive impact on the film stability.

- The maximum value of the imaginary part of the dielectric constant.

    o This property is an indirect measurement of the film density. A higher value denotes a denser film.

- The film thickness and so the deposition rate.

    o In the present operating conditions, the plasma operates in silane depletion mode at high MW power and the deposition rate is directly proportional to the silane flow rate.

The electronic properties of the films are deduced from conductivity measurements.

- The film photoconductivity, measured between two coplanar electrodes on the film surface.

    o It is a measure of the film electronic quality under bias.
    o Typically a better material shows a larger conductivity under illumination but the effect of charge traps may be annihilated by the large electric field.

- The illumination factor (IF0) which is the ratio between the photoconductivity and the dark conductivity.

    o For an amorphous material the higher the value, the better the material.
    o In the present case it was measured prior to annealing the layer and is hence more subject to the presence of defects that may disappear upon annealing.

- The minority carriers (hole) diffusion length was measured by SSPG (Steady State Photo-carrier Grating).

    o It consists in irradiating a sample with a polarized laser beam split into 2. Both beams interfere in the sample producing an interference grating when polarized parallel and uniform illumination when polarized perpendicular.
    o The ambipolar diffusion length is deduced from the ratio of the "interference" and the "uniform" illumination photoconductivities when changing the grating period and the angle of incidence.

**Table 1**

| Ex | Injection | $SiH_4/m^2$ | Residence time | MW/gas | RF bias | Temp | RF Power | Pgas | Pplasma |
|----|-----------|-------------|---------------|--------|---------|------|----------|------|---------|
|    |           | sccm/m$^2$  | ms            | W/sccm | Volts   | C    | W        | mTorr | mTorr  |
| 1  | Point     | 712         | 30.80         | 60.00  | -114    | 225  | 300      | 0.77 | 5.56    |

(continued)

| Ex | Injection | SiH$_4$/m$^2$ | Residence time | MW/gas | RF bias | Temp | RF Power | Pgas | Pplasma |
|---|---|---|---|---|---|---|---|---|---|
| | | sccm/m$^2$ | ms | W/sccm | Volts | C | W | mTorr | mTorr |
| 2 | Point | 712 | 21.44 | 60.00 | -57 | 225 | | 0.53 | 1.82 |
| 3 | Point | 712 | 21.04 | 20.00 | -114 | 225 | 170 | 0.52 | 1.74 |
| 4 | Point | 712 | 32.41 | 20.00 | -57 | 225 | | 0.81 | 5.36 |
| 5 | Point | 2136 | 21.10 | 20.00 | -114 | 225 | | 1.57 | 9.57 |
| 6 | Point | 2136 | 31.61 | 20.00 | -57 | 225 | | 2.36 | 30.72 |
| 7 | Point | 2136 | 21.37 | 6.67 | -57 | 225 | | 1.59 | 8.04 |
| 8 | Point | 2136 | 21.24 | 6.67 | -57 | 225 | | 1.58 | 8.79 |
| 9 | Point | 2136 | 31.61 | 6.67 | -114 | 225 | | 2.36 | 24.91 |
| 10 | Point | 2848 | 24.76 | 5.00 | -100 | 225 | | 2.46 | 15.04 |
| 11 | Point | 2136 | 36.51 | 6.67 | -100 | 225 | | 2.72 | 37.04 |
| 12 | Point | 2136 | 25.37 | 4.67 | -100 | 225 | | 1.89 | 8.88 |
| 13 | Point | 2848 | 28.70 | 3.50 | -100 | 225 | | 2.85 | 24.44 |
| 14 | Point | 2848 | 28.70 | 3.50 | -76 | 225 | | 2.85 | 24.44 |
| 15 | Point | 2848 | 28.70 | 3.50 | -57 | 225 | | 2.85 | 24.44 |
| 16 | Point | 2848 | 28.70 | 3.50 | -38 | 225 | | 2.85 | 24.44 |
| 17 | Point | 2848 | 28.70 | 3.50 | -19 | 225 | | 2.85 | 24.44 |
| 18 | Tube | 1495 | 27.61 | 19.05 | -25 | 225 | 44 | 1.44 | 6.13 |
| 19 | Tube | 1495 | 27.80 | 19.05 | -25 | 225 | 37 | 1.45 | 6.17 |
| 20 | Tube | 1495 | 29.72 | 19.05 | -25 | 225 | 31 | 1.55 | 10.39 |
| 21 | Tube | 1495 | 33.74 | 19.05 | -25 | 225 | 21 | 1.76 | 18.96 |
| 22 | Tube | 1495 | 34.56 | 19.05 | -25 | 225 | 19 | 1.80 | 20.76 |
| 23 | Tube | 1495 | 27.61 | 19.05 | -25 | 275 | 44 | 1.44 | 6.13 |
| 24 | Tube | 1495 | 30.29 | 19.05 | -25 | 275 | 35 | 1.58 | 10.64 |
| 25 | Tube | 1495 | 33.94 | 19.05 | -25 | 275 | 25 | 1.77 | 19.13 |

**Table 2**

| Ex | d | Rough | Rate | $\varepsilon_i$(max) | Eg | C | Ld | IFO | Sigma Phot |
|---|---|---|---|---|---|---|---|---|---|
| | Å | Å | Å/s | | eV | | nm | | 1/ohm.cm |
| 1 | 5612 | 11 | 18.73 | 24.40 | 1.805 | 2.06 | | | 3.92E-08 |
| 2 | 5152 | 16 | 17.20 | 22.50 | 1.828 | 2.13 | | | 2.60E-08 |
| 3 | 3410 | 9 | 11.38 | 23.10 | 1.886 | 2.07 | | | 2.76E-08 |
| 4 | 3609 | 11 | 12.05 | 24.30 | 1.823 | 2.21 | | | |
| 5 | 6860 | 12 | 38.14 | 24.90 | 1.788 | 2.16 | | 4900 | |
| 6 | 6115 | 61 | 40.97 | 23.30 | 1.758 | 2.44 | | 21 | 9.16E-07 |
| 7 | 3234 | 35 | 21.68 | 29.00 | 1.698 | 2.13 | | | 5.95E-07 |
| 8 | 3049 | 35 | 20.33 | 27.85 | 1.710 | 2.20 | | 4000 | 5.08E-07 |

(continued)

| Ex | d | Rough | Rate | $\varepsilon_i$(max) | Eg | C | Ld | IFO | Sigma Phot |
|---|---|---|---|---|---|---|---|---|---|
| | Å | Å | Å/s | | eV | | nm | | 1/ohm.cm |
| 9 | 1928 | 51 | 13.02 | 25.60 | 1.736 | 2.34 | | | 1.89E-07 |
| 10 | 5746 | 41 | 19.15 | 25.40 | 1.725 | 2.33 | | 3975 | 8.354E-07 |
| 11 | 4554 | 65 | 615.18 | 22.71 | 1.731 | 2.59 | | 627 | 1.757E-06 |
| 12 | 5112 | 18 | 17.04 | 24.46 | 1.737 | 2.36 | | 2179 | 4.93E-07 |
| 13 | 3850 | 51 | 12.83 | 24.27 | 1.722 | 2.57 | | 3567 | 6.545E-07 |
| 14 | 3810 | 52 | 12.70 | 23.71 | 1.727 | 2.65 | | 4083 | 6.299E-07 |
| 15 | 3816 | 61 | 12.72 | 23.10 | 1.747 | 2.67 | | 920 | 4.403E-07 |
| 16 | 3695 | 58 | 12.32 | 24.03 | 1.743 | 2.59 | | 1325 | 7.037E-07 |
| 17 | 3748 | 69 | 12.49 | 21.65 | 1.776 | 2.78 | | | |
| 18 | 2683 | 30.6 | 24.40 | 24.52 | 1.774 | 2.45 | 100.00 | | |
| 19 | 2800 | 27.9 | 25.44 | 24.82 | 1.760 | 2.45 | 140.00 | | |
| 20 | 2675 | 44.15 | 25.49 | 23.16 | 1.779 | 2.55 | 70.00 | | |
| 21 | 2711 | 56 | 25.82 | 19.88 | 1.809 | 2.77 | 20.00 | | |
| 22 | 2748 | 58.85 | 24.99 | 19.42 | 1.812 | 2.81 | 20.00 | | |
| 23 | 2677 | 23.7 | 24.34 | 25.66 | 1.741 | 2.39 | 110.00 | | |
| 24 | 2734 | 32.1 | 24.85 | 24.51 | 1.726 | 2.47 | 90.00 | | |
| 25 | 2682 | 45 | 24.38 | 22.68 | 1.747 | 2.62 | 30.00 | | |

As mentioned above, one of the findings on which the present invention is based is that certain improvements are associated with a low precursor gas residence time. For the purpose of the present invention, the gas residence time for a given DECR reactor is defined as the volume of the reactor enclosure, expressed in 1, divided by the effective pumping rate at which the vacuum pump is operating, expressed in l/s. The effective pumping rate is the rate at which gas is actually being extracted from the reactor. Because of the presence of a connecting pipe between the plasma/ deposition chamber and the turbo-molecular pump, the vacuum pump will actually be pumping at a lower rate than its nominal rating (i.e. its pumping rate at the entrance to the pump) due to the change in conductance as a result of the pipe. The examples given in Tables 1 and 2 were derived from a reactor which, as mentioned above, had a volume of 25.5 1.

The results achieved are discussed below with reference to graphs showing how various film properties are found to vary in dependence on gas flow rate and/or gas residence time. The effect of each of these features will first be considered separately, and then in combination.

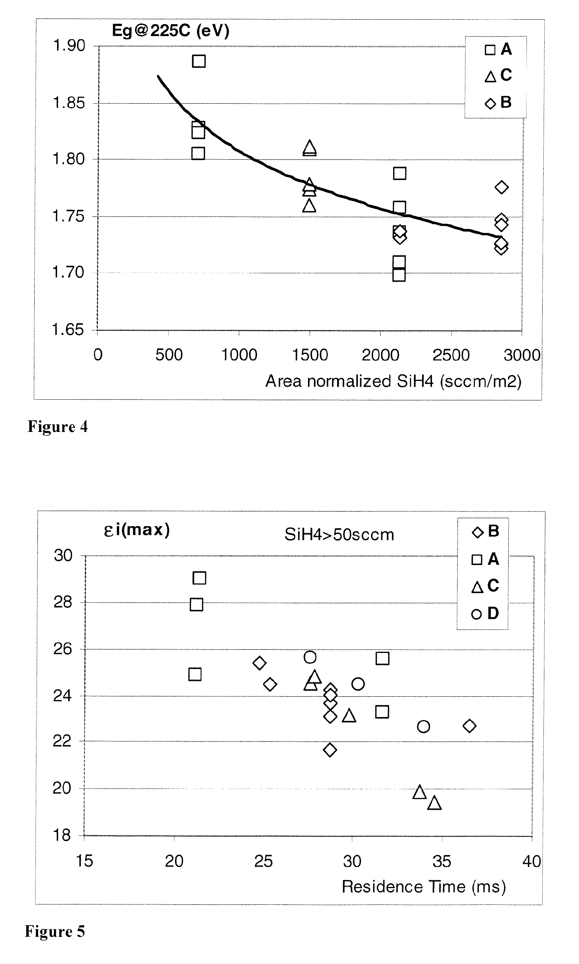

Increasing the silane flow rate, and hence the deposition rate, has been found to have a large effect on the material bandgap which decreases as the flow rate increases. This is also clearly seen by looking at films of equal thickness, made at increasing flow rates, and observing that the higher the flow rate the darker the resulting film. Figure 4 shows that a higher flow rate leads to significantly smaller band-gap.

Hence, based on the quality criteria discussed above, to achieve a material bandgap, suitable for use in thin film solar cells, the area-normalized silane flow rate should be as high as possible and in any case should exceed 700sccm/m$^2$. Preferably the flow rate should be at least 1000 sccm/m$^2$, more preferably at least 1500 sccm/m$^2$, still more preferably at least 2000 sccm/m$^2$, and yet more preferably at least 2500 sccm/m$^2$. There is, however, no upper limit relative to this criterion, though an upper limit will arise from hardware or economic limitations when combined with the requirements on the residence time (discussed below).

**Gas residence time**

**Material density**

The film density was measured via the maximum value of the imaginary part ($\varepsilon_i$(max)) of the film dielectric constant. As shown in Figure 5, $\varepsilon_i$(max), and thus film density, increases with decreasing gas residence time. The temperature also has an effect, as raising the substrate temperature tends to densify the material. However within the range investigated, the gas residence time plays the major role and short gas residence times are much preferred to achieve the highest possible material density.

The silane flow rate has a small effect on the dielectric constant but this will be further discussed for other quality parameters for which the effect is much larger.

Looking at the minimal criterion to fulfil for solar use, the gas residence time should be not more than 30 ms to satisfy the $\varepsilon_i$(max) criterion.

## Charge transport properties

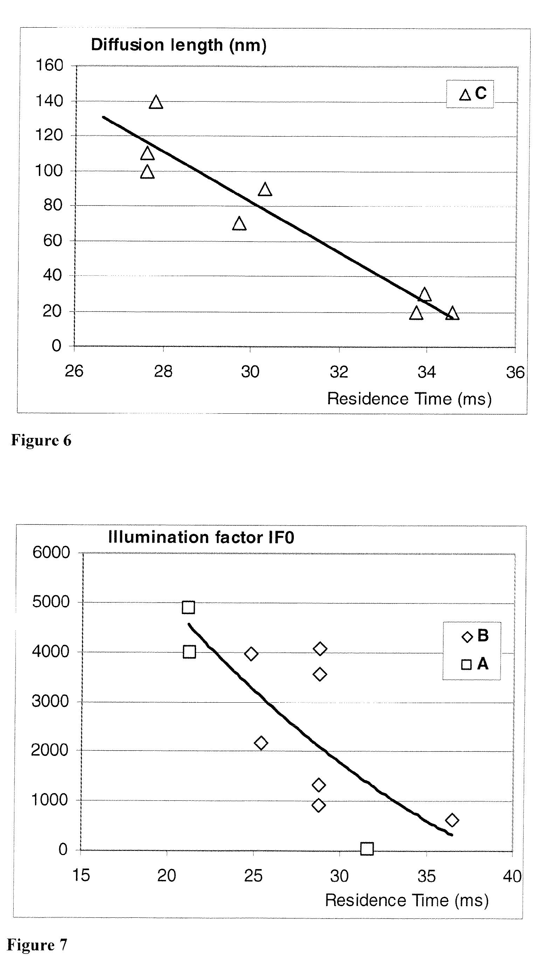

The electrical properties of the material can be assessed by looking at the charge transport properties, such as the minority carrier diffusion length (Ld), or comparing the photoconductivity with the dark conductivity (referred as the illumination factor, IF0). In both cases, these properties are essentially influenced by the gas residence time as can be seen in Figures 6 and 7.

The achievement of a particular illumination factor is not used herein to derive a criterion for the method by which the film should be made. This is because although a larger illumination factor indicates a better material quality, there is no correlation between the achievement of a particular illumination factor, and the obtaining of a material of a particular quality. However, it has been discovered that decreasing the silane gas residence time positively affects the illumination factor.

On the other hand, it was determined that the minority carrier diffusion length should be larger than 100nm. Based on the data presented, it was found that the gas residence time should be not more than 30ms to achieve such goal.

In conclusion, based on the morphological, optical, electrical and charge transport properties of the aSi:H layers deposited by DECR, the gas residence time should be not more than 30ms to achieve a material quality good enough for use in a thin film solar cell. Preferably, it should be less than 28ms, more preferably less than 25ms, and still more preferably less than 22ms.

## Combination of gas residence time and area-normalized gas flow rate

For the properties discussed above, the area-normalized gas flow rate and the gas residence time do not show cross-interactions. This means that each can be set independently to achieve a good material quality. However, it has been discovered that this is not the case for all the properties and several depend in an inter-related way on both the precursor gas flow rate and the precursor gas residence time. This is the case for surface roughness and the matrix disorder parameter.

Surface roughness is not per se a criterion of quality for making solar cells. However, the rule of thumb is that rough films do not allow making good thin film solar cells. This is particularly true when the last layer deposited is the window layer, as it needs to be very thin and form a conformal layer on the deposited film. Failing to form a conformal layer leads to shunt and inhomogeneity of the electric field inside the thin film solar cell, which dramatically affect the cell conversion efficiency. The process conditions are hence made such that the material roughness is minimized. This will be particularly valid if the window layer is deposited by a low density/low pressure plasma process such as magnetron sputtering.

As can be seen from Tables 1 and 2 surface roughness is influenced by a combination of the silane flow rate/gas residence time as well as by the substrate bias. The data in the tables indicate that to achieve low surface roughness, the residence time should be as short as possible and the flow rate should be as high as possible. The same type of trend is observed for the matrix disorder parameter C for which it is desirable to achieve a low value.

## Claims

1. A method for forming a film of an amorphous material on a substrate, by deposition from a plasma, which comprises placing the substrate in an enclosure having a defined volume, continuously introducing into the enclosure a film precursor gas at a flow rate, extracting unreacted and dissociated gas from the enclosure so as to provide a low pressure in the enclosure, and introducing microwave energy into gas within the enclosure to produce a plasma therein by distributed electron cyclotron resonance (DECR) and cause material to be deposited from the plasma on the substrate, wherein the normalised precursor gas flow rate, defined as the precursor gas flow rate, divided by the area of the distributed plasma source, is greater than or equal to 700sccm/m$^2$, and the gas residence time, defined as the volume of the reactor divided by the effective precursor gas pumping rate, is not more than 30ms.

**2.** A method according to claim 1, wherein the film deposited is hydrogenated amorphous silicon.

**3.** A method according to claim 2, wherein the film precursor gas comprises a silicon hydride.

**4.** A method according to claim 3, wherein the film precursor gas comprises $SiH_4$.

**5.** A method according to claim 1, wherein the film deposited is an amorphous silicon alloy.

**6.** A method according to any preceding claim, wherein the plasma is produced by devices arranged to form a two-dimensional network.

**7.** A method according to claim 6, wherein the plasma is produced by matrix DECR.

**8.** A method according to any preceding claim, wherein the pressure in the enclosure is from $10^{-4}$ Pa to 1 Pa.

**9.** A method according to claim 8, wherein the pressure is at least $10^{-2}$ Pa.

**10.** A method according to claim 8 or 9, wherein the pressure is not more than $2 \times 10^{-1}$ Pa.

**11.** A method according to any preceding claim, wherein a DC voltage bias is imparted to the substrate by an RF generator.

**12.** A method according to any preceding claim, wherein the said normalised precursor gas flow rate is at least 1000, preferably at least 1500, more preferably 2000, and still more preferably 2500 sccm/m$^2$.

**13.** A method according to any preceding claim, wherein the said gas residence time is less than 28ms, preferably less than 25ms, more preferably less than 22ms.

**Figure 1**

**Figure 2**

**Figure 3a**

**Figure 3b**

Figure 3c

Figure 3d

Figure 4

Figure 5

Figure 6

Figure 7

**Figure 8a**

Figure 8b

**European Patent Office**

**EUROPEAN SEARCH REPORT**

Application Number

EP 06 30 1113

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BULKIN P ET AL: "Deposition of silicon alloys in an integrated distributed electron cyclotron resonance reactor: Oxide, nitride, oxinitrides, and multilayer structures" JOURNAL OF VACUUM SCIENCE AND TECHNOLOGY A. VACUUM, SURFACES AND FILMS, AMERICAN INSTITUTE OF PHYSICS, NEW YORK, NY, US, vol. 20, no. 2, March 2002 (2002-03), pages 338-343, XP012005960 ISSN: 0734-2101 * the whole document * | 1-13 | INV. C23C16/24 C23C16/511 H01J37/32 H01L31/20 |
| A | GIRARD G ET AL: "Matrix-distributed ECR-PECVD for high-rate deposition of silica for applications in integrated optics" PROCEEDINGS OF THE SPIE - THE INTERNATIONAL SOCIETY FOR OPTICAL ENGINEERING SPIE-INT. SOC. OPT. ENG USA, vol. 4944, 2003, pages 62-71, XP002436134 ISSN: 0277-786X * page 62, line 30 - page 64, line 43; figure 1 * | 1-13 | |
| A | DAINEKA D ET AL: "Control and monitoring of optical thin films deposition in a matrix distributed electron cyclotron resonance reactor" EUROPEAN PHYSICAL JOURNAL, APPLIED PHYSICS EDP SCIENCES FRANCE, vol. 28, no. 3, December 2004 (2004-12), pages 343-346, XP002436180 ISSN: 1286-0042 * page 343, column 2, line 17 - page 345, column 2, line 6; figure 5 * | 1-7 | TECHNICAL FIELDS SEARCHED (IPC) C23C H01J H01L |

The present search report has been drawn up for all claims

| Place of search | Date of completion of the search | Examiner |
|---|---|---|
| The Hague | 5 June 2007 | Lavéant, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6407359 B
- EP 1075168 A

### Non-patent literature cited in the description

- **T. LAGARDE ; Y. ARNAL ; A. LACOSTE ; J. PELLETIER.** Determination of the EEDF by Langmuir probe diagnostic in a plasma excited at ECR above a multipolar magnetic field. *Plasma Sources Sci. Technol.,* 2001, vol. 10, 181-190
- **MICHEL MOISAN ; JACQUES PELLETIER.** Microwave Excited Plasmas. Elsevier, 1992
- **SUZUKI et al.** Radio-frequency biased microwave plasma etching technique: A method to increase SiO2 etch rate. *J. Vac. Sci. Technol. B,* July 1985, vol. 3 (4), 1025-1033
- **A. FONTCUBERTA I MORRAL ; P. ROCA I CABARROCAS ; C. CLERC.** Structure and hydrogen content of polymorphous silicon thin films studied by spectroscopic ellipsometry and nuclear measurements. *PHYSICAL REVIEW B,* 2004, vol. 69